# EUROPEAN PATENT SPECIFICATION

(11) **EP 1 142 112 B1**
(45) Date of publication and mention of the grant of the patent: **20.04.2005**
(21) Application number: 99961251.8
(22) Date of filing: 22.12.1999
(51) Int. Cl.: H03J 7/20, H03C 3/09, H03B 23/00, E05B 49/00

(54) **A RECEIVER AND A VARIABLE FREQUENCY SIGNAL GENERATING CIRCUIT FOR THE RECEIVER**
EMPFÄNGER UND FREQUENZVERÄNDERBARER SIGNALGENERATOR DAFÜR
RECEPTEUR ET CIRCUIT DE GENERATION DE SIGNAUX A FREQUENCE VARIABLE POUR LE RECEPTEUR

(30) Priority: 22.12.1998 IE 981091; 22.12.1998 IE 981092
(43) Date of publication of application: 10.10.2001
(73) Proprietor: HI-KEY Limited, Tuam, County Galway (IE)
(72) Inventor: LYONS, Patrick John, Moylough, County Galway (IE)
(74) Representative: Gorman, Francis Fergus
(86) International application number: PCT/IE1999/000142
(87) International publication number: WO 2000/038320

(56) References cited:
- EP-A- 0 570 761
- EP-A- 0 926 021
- EP-A- 0 930 705
- US-A- 3 965 438
- US-A- 4 533 866

## Description

The present invention relates to a receiver, and in particular to a variable frequency radio receiver for receiving, for example, signals of the type transmitted by a keyfob or other such transmitter for use in a remote keyless entry system of a vehicle, for example, a motor vehicle such as, a car, van, truck and the like.

Remote keyless entry systems, in general, comprise an electronic control unit which controls various components in a motor vehicle, for example, an alarm circuit, a vehicle immobiliser unit, the central locking system of the vehicle and other security aspects of the vehicle which protect the vehicle when unattended. A radio receiver which may be incorporated in the electronic control unit, or may be a stand alone receiver communicating with the electronic control unit receives remotely transmitted signals which are typically transmitted from a remote transmitter, for example, a keyfob transmitter. The transmitted signals, in general, comprise a preamble code followed by a unique code embedded in the signal. The preamble code typically is common to a number of electronic control units of similar type, and the unique code is unique to one specific electronic control unit. On reception of a valid signal with a unique code specific to the electronic control unit the electronic control unit changes the state of the various components of the vehicle which it controls. For example, in the case of an alarm circuit, if the alarm circuit is armed, on reception of a valid unique signal the electronic control unit disarms the alarm circuit, and vice versa. In the case of the vehicle immobiliser unit if the vehicle is immobilised by the immobiliser unit, on reception of the valid unique signal the vehicle immobiliser unit is deactivated from mobilising the vehicle, and vice versa. Similarly, in the case of the central locking system if the doors of the vehicle are locked, on reception of a valid unique signal the electronic control unit operates the central locking system for unlocking the doors, and vice versa.

In order to avoid jamming of the transmitted signal it is now common for keyfob transmitters to transmit the signal on two frequencies either simultaneously or sequentially, and furthermore, it is known to vary the frequencies at which the signal is transmitted from transmission to transmission. Accordingly, the radio receiver must be capable of receiving signals over a range of frequencies, and furthermore the radio receiver must be capable of sweeping the frequency range. In general, the frequency range is relatively narrow, however, it is still essential that the radio receiver should be capable of sweeping the frequency range, and in general, it is necessary that the frequency range should be continuously swept.

While radio receivers for sweeping through a range of frequencies are known, in general, they suffer from a number of disadvantages. For example, in general, they tend to be of relatively high cost, since in general, it is necessary to provide a relatively accurate frequency source, and a relatively tight tolerance is required on the intermediate frequency filter components. Additionally, in many cases manual fine tuning of the receiver is often necessary during production test. Furthermore, in general, the transmitter must also be provided with a relatively accurate frequency source.

U.S. Patent Specification No. 4,533,866 of Zirwick discloses a circuit for setting a voltage controlled oscillator of a spectrum analyser at a predetermined frequency. The voltage controlled oscillator is connected into a phase control loop of a frequency synthesiser. An adjustable frequency divider divides the output frequency of the voltage controlled oscillator, and delivers the divided frequency to a phase comparator, which compares the divided frequency with a reference frequency, and produces a tuning voltage. One switch of a switch network selectively switches the tuning voltage to a storing capacator of a control circuit. Another switch of the switch network selectively and alternately switches the tuning voltage directly to the voltage controlled oscillator, and a control voltage signal from the control circuit to the voltage controlled oscillator. The control voltage signal comprises the previously stored tuning voltage summed with a voltage signal from a sawtooth generator for sweeping the output frequency of the voltage controlled oscillator about a centre frequency precisely defined by the synthesiser setting.

U.S. Patent Specification No. 3,965,438 of Winston discloses a circuit for maintaining the centre frequency of a swept voltage controlled oscillator. An adjustable frequency divider divides the output frequency of the voltage controlled oscillator, and a phase/frequency detector detects the phase difference between the divided frequency and a reference frequency and provides a proportional voltage signal. At a known amplitude of the sweep voltage input a lock pulse is actuated. The proportional voltage signal from the phase/frequency detector is applied via a gate under the control of a lock pulse to a memorising circuit, the output of which is applied with a sweep input voltage to the voltage controlled oscillator. The lock pulse is actuated at a known amplitude of the sweep voltage input, so that the output from the memorising circuit resulting from the proportional voltage signal gated to the memorising circuit maintains the frequency output of the voltage controlled oscillator at the centre frequency.

There is therefore a need for a variable frequency radio receiver for a remote keyless entry system of a motor vehicle, and there is also a need for a variable frequency radio receiver for other purposes.

The present invention is directed towards providing such a radio receiver.

According to the invention there is provided a variable frequency receiver for receiving a remotely transmitted signal within a predetermined reception frequency range, wherein the receiver comprises a receiving means for receiving the remotely transmitted signal, a variable frequency signal generating means for outputting a variable frequency output signal, a mixing means for mixing the received signal with the variable frequency output signal and for outputting the mixed signal at a frequency dependent on the frequency of the variable frequency output signal and the frequency of the received signal, a gate means for outputting a signal derived from the mixed signal, and a control means for reading the signal from the mixed signal and for determining if the received signal is a valid signal, the control means controlling the gate means for outputting the signal derived from the mixed signal in response to the received signal being a valid signal, the control means controlling the variable frequency signal generating means for holding the frequency of the variable frequency output signal constant until the signal derived from the mixed signal has been outputted through the gate means.

In one embodiment of the invention the control means operates the variable frequency signal generating means for selectively and sequentially varying the frequency of the variable frequency output signal for sweeping the variable frequency output signal through a predetermined frequency range between a predetermined lower frequency and a predetermined upper frequency.

In another embodiment of the invention the predetermined upper and lower frequencies of the variable frequency output signal are selected for facilitating reception of received signals within the predetermined reception frequency range.

In a further embodiment of the invention the control means monitors the time between data edges of the received signal for determining if the received signal is of a valid signal.

In another embodiment of the invention the variable frequency signal generating means is in the form of a phase locked loop circuit and comprises a variable frequency voltage controlled oscillator having a control input port for receiving a control signal for determining the output frequency of the variable frequency output signal of the voltage controlled oscillator, a constant frequency signal generating means for generating a constant frequency signal, a phase comparing means for comparing the variable frequency output signal with the constant frequency signal and for outputting a signal indicative of the phase shift between the two signals, a feedback loop for feeding back the signal from the phase comparing means to the control input port of the voltage controlled oscillator for completing the phase locked loop circuit, a first isolating means in the feedback loop for isolating the control input port of the voltage controlled oscillator from the phase comparing means when the circuit has locked-up, a retaining means for holding the signal from the phase comparing means on the control input port of the voltage controlled oscillator after the first isolating means has isolated the control input port from the phase comparing means, a signal varying means for selectively varying the signal on the control input port of the voltage controlled oscillator while the control input port is isolated from the phase comparing means for in turn selectively varying the frequency of the variable frequency output signal, and the first isolating means being controlled by the control means for isolating the control input port from the phase comparing means and for operating the signal varying means for selectively varying the signal on the control input port when the control input port is isolated from the phase comparing means.

In one embodiment of the invention the control means controls the signal varying means for selectively and sequentially incrementing or decrementing the value of the signal on the control input port over a predetermined range of signal values between a predetermined lower signal value and a predetermined upper signal value for sweeping the frequency of the variable frequency output signal through the predetermined frequency range.

In another embodiment of the invention the control means controls the signal varying means for holding the signal value on the control input port of the voltage controlled oscillator constant at each signal value within the predetermined range of signal values for a first predetermined time period.

Preferably, the control means controls the signal varying means for holding the value of the signal on the control input port of the voltage controlled oscillator constant at selected signal values within the predetermined range of signal values for a second predetermined time period, the second predetermined time period being greater than the first predetermined time period.

Advantageously, the control means controls the signal varying means for selectively and sequentially incrementing the signal on the control input port of the voltage controlled oscillator through a plurality of incremental signal value steps from the lower predetermined signal value to the upper predetermined signal value for sweeping the variable frequency output signal through the predetermined frequency range.

Ideally, the control means controls the signal varying means for returning the signal value on the control input port to one of the predetermined lower and upper signal values when the signal value on the control input port is at the other of the predetermined lower and upper signal values.

In one embodiment of the invention the signal outputted from the phase comparing means is a DC voltage signal when the phase lock loop has locked-up.

In another embodiment of the invention the signal varying means comprises a means for selectively and sequentially generating a variable DC voltage, and an adding means for adding the variable DC voltage to the voltage signal from the phase comparing means held on the control input port of the voltage controlled oscillator.

In a further embodiment of the invention the adding means comprises a voltage adder.

In another embodiment of the invention the signal varying means comprises a digital to analogue converter operating under the control of the control means for outputting the variable DC voltage to the control input port of the voltage controlled oscillator.

Preferably, the first isolating means comprises a first switch means operable under the control of the control means, the first switch means being located in the feedback loop between the phase comparing means and the signal varying means.

Advantageously, the retaining means is provided by a capacitive retaining circuit connected to the feedback loop between the first isolating means and the signal varying means.

Preferably, the capacitive retaining circuit comprises a capacitor connected between the feedback loop and ground.

In one embodiment of the invention a first impedance means is provided in the capacitive retaining circuit for smoothing charging of the capacitor during periods when the control input port of the voltage controlled oscillator is communicating with the phase comparing means.

In another embodiment of the invention a second isolating means operable under the control of the control means is provided in the capacitive circuit for switching out the first impedance means when the control input port of the voltage controlled oscillator is isolated from the phase comparing means.

Preferably, the second isolating means is provided by a second switch means.

Advantageously, the control means operates the second isolating means for switching out the first impedance means when the first isolating means is isolating the control input port of the voltage controlled oscillator from the phase comparing means, and vice versa.

In one embodiment of the invention a low pass filter for filtering the signal from the phase comparing means to the control input port of the voltage controlled oscillator is provided in the feedback loop.

In another embodiment of the invention the comparing means comprises a phase comparator.

In a further embodiment of the invention the constant frequency signal generating means comprises a constant frequency generator.

In a still further embodiment of the invention the constant frequency generator is provided by a crystal generator.

Advantageously, the control means operates the first isolating means periodically for closing the feedback loop for communicating the control input port of the voltage controlled oscillator with the phase comparing means for permitting periodic lock-up of the phase locked loop circuit for avoiding deterioration of the signal on the control input port.

In another embodiment of the invention the control means of the voltage controlled oscillator is responsive to the presence of a valid received signal for controlling the signal varying means for holding the signal value on the control input port of the voltage controlled oscillator constant for in turn holding the frequency of the variable frequency output signal constant for the second predetermined time period for facilitating reception of the received signal.

In a further embodiment of the invention the second predetermined time period is of sufficient duration for facilitating reception of at least one valid received signal.

In one embodiment of the invention an intermediate filter means is provided for filtering the mixed signal and for outputting a signal filtered from the mixed signal the frequency of which is a predetermined value derived from the difference between the frequencies of the variable frequency output signal and corresponding frequencies at which it is desired to receive the remotely transmitted signal.

In another embodiment of the invention a demodulating means is provided for demodulating the signal outputted by the intermediate filter means for extracting data therefrom.

In a further embodiment of the invention the gate means outputs the data extracted from the received signal by the demodulating means.

Preferably, the control means reads the data signal from the demodulating means and the time period between the edges of the demodulated signal for determining if the received signal is of a valid format.

Advantageously, the control means controls the gate means for outputting the demodulated signal in response to the control means determining that the data signal is in valid format.

In one embodiment of the invention the predetermined frequency range through which the variable frequency output signal from the voltage controlled oscillator is swept is such as to facilitate reception of a received signal over the predetermined reception frequency range.

In another embodiment of the invention the predetermined reception frequency range is in the order of 400KHz.

In a further embodiment of the invention the predetermined upper and lower frequency values of the variable frequency output signal from the voltage controlled oscillator is such as to facilitate reception of a received signal between a predetermined lower reception frequency of 433.72MHz and a predetermined upper reception frequency of 434.12MHz.

In a still further embodiment of the invention the predetermined frequency range of the variable frequency output signal of the voltage controlled oscillator is in the order of 400KHz.

In a further embodiment of the invention the predetermined lower frequency of the variable frequency output signal of the voltage controlled oscillator is in the order of 423.02MHz and the predetermined upper frequency of the variable frequency output signal is in the order of 423.42MHz.

In one embodiment of the invention the intermediate filter means filters out signals of frequencies other than frequencies in the order of 10.7MHz.

Preferably, a saw filter is provided for filtering the received signal to the mixing means, and for filtering out signals of frequency outside the predetermined reception frequency range.

The invention also provides a remote keyless entry system for a motor vehicle comprising the variable frequency receiver according to the invention.

The advantages of the invention are many. The variable frequency radio receiver according to the invention provides a relatively low cost and accurate receiver. By providing the variable frequency radio with the variable frequency signal generating means manual fine tuning of the receiver is unnecessary. The variable frequency signal generating means provides a relatively simple and low cost circuit which provides a relatively accurate variable frequency output signal, and the variable frequency signal generating circuit does not require relatively high precision and high cost components for providing the relatively accurate variable frequency output signal. In particular, a relatively accurate constant frequency signal generating source is not required.

The invention will be more clearly understood from the following description of some preferred embodiments thereof which are given by way of example only with reference to the accompanying drawings, in which:
Fig 1. is a block representation of a variable frequency receiver according to the invention for a remote keyless entry system of a motor vehicle,
Fig 2. is a block representation of a variable frequency signal generating circuit of the receiver of Fig 1,
Fig. 3 is a graphical representation of a variable frequency signal generated by the variable frequency signal generating circuit of Fig. 2, and
Fig. 4 is a block representation of a variable frequency receiver according to another embodiment of the invention for a remote keyless entry system of a motor vehide.

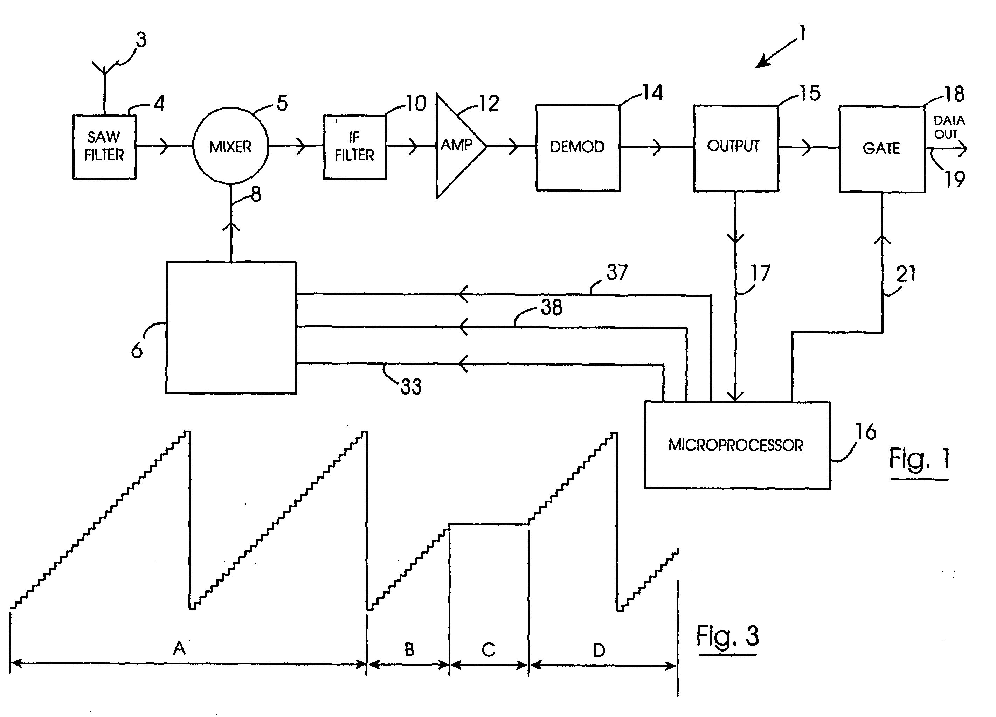

Referring to the drawings and initially to Figs. 1 to 3 thereof, there is illustrated a narrow band variable frequency radio receiver according to the invention indicated generally by the reference numeral 1, which is panicutarty suitable for use in connection with an electronic control unit (not shown) of a remote keyless entry system of a motor vehicle (also not shown). The electronic control unit although not illustrated will be well known to those skilled in the art, and the receiver 1 may be provided internally within the electronic control unit or may be a stand alone receiver communicating with the electronic control unit. The electronic control unit may control various components in the motor vehicle, for example, an alarm circuit, a vehicle immobiliser unit, the central locking system of the vehicle and other security aspects of the vehicle which protect the vehicle when unattended. As will be described below on reception of a signal in valid format the radio receiver 1 outputs a demodulated form of the received signal which contains the data embedded in the signal to the electronic control unit, and on the electronic control unit determining that the signal is a unique valid signal unique to the electronic control unit, the electronic control unit appropriately operates the various components in the motor vehicle which are controlled by the electronic control unit. For example, in the event that the alarm circuit of the vehicle is in a disarmed state, on reception of a valid unique signal the electronic control unit arms the alarm circuit, and typically, operates the immobiliser unit for immobilising the vehicle, and the central locking system for locking the vehicle. On reception of a valid unique signal when the alarm circuit is in an armed state, the electronic control unit disarms the alarm circuit, and typically, operates the immobilising unit for mobilising the vehicle, and the central locking system for unlocking the vehicle.

The receiver 1 is adapted for receiving radio signals, typically, transmitted by a keyfob transmitter (not shown) within a predetermined narrow band frequency range of 400KHz between a predetermined lower reception frequency of 433.72MHz and a predetermined upper reception frequency of 434.12MHz. The transmitted signals, typically, comprise a preamble code followed by a unique code, both of which are embedded in the transmitted signal. The preamble code typically is common to a number of electronic control units of similar type, and the unique code is unique to one specific electronic control unit. The frequency of the transmitted signals are randomly selected within the predetermined frequency range of 433.72MHz and 434.12MHz in thirty-two 12.5KHz steps for each transmission, and two or more transmission frequencies may be selected for each transmission.

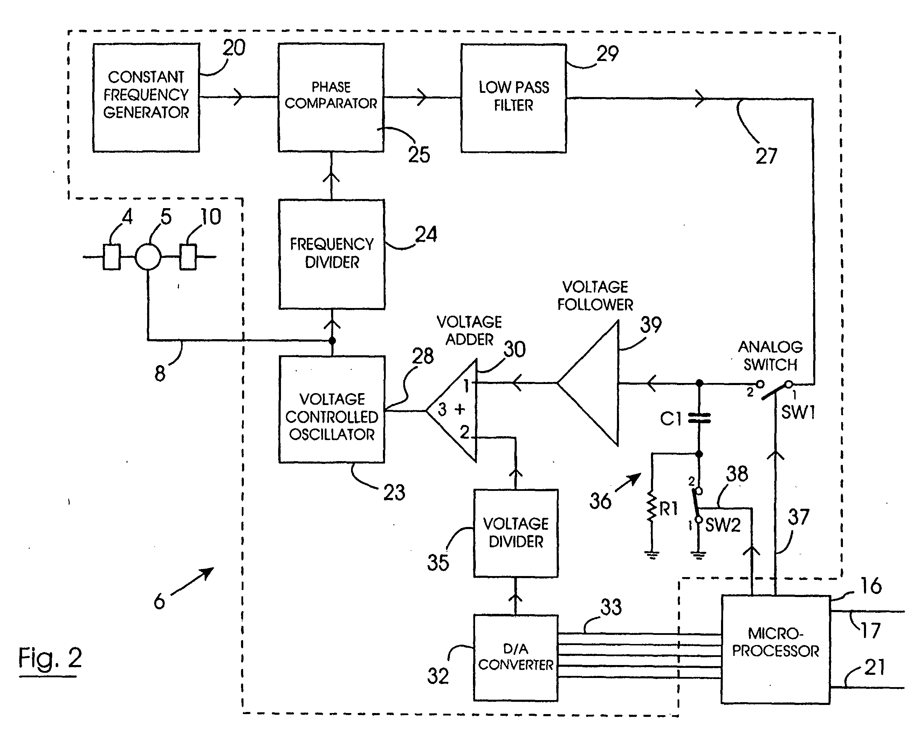

An antenna 3 at the front end of the receiver 1 receives the remotely transmitted radio signals from the keyfob transmitter (not shown) or other suitable transmitter, and feeds the received signals to a saw filter 4 which filters out signals of frequencies outside the predetermined reception frequency range of 433.72MHz to 434.12MHz. Received frequencies within the reception frequency range of 433.72MHz to 434.12MHz are fed from the saw filter 4 to a mixing means, namely, a mixer 5 which mixes the received signals with a variable frequency output signal generated by a variable frequency signal generating circuit indicated by the reference numeral 6. The circuit 6 which is described in detail below with reference to Fig. 2 feeds the variable frequency output signal on a line 8 to the mixer 5, and the frequency of the variable frequency output signal is swept through a predetermined frequency range of 400KHz from a predetermined lower frequency of 423.02MHz to a predetermined upper frequency of 423.42MHz in thirty-two incremental steps of 12.5KHz. This is described in detail below.

The mixer 5 outputs two signals, one of which is at a frequency equal to the sum of the frequencies of the received signal and the variable frequency output signal, and the other is at a frequency equal to the difference of the frequencies of the received signal and the variable frequency output signal from the circuit 6. By selecting the lower and upper frequencies of the variable frequency output signal at 423.02MHz and 423.42MHz, respectively, the frequency difference between the received signal and the variable frequency output signal for corresponding values of the received signal and variable frequency output signal will always be 10.7MHz if the received signal is within the predetermined lower and upper reception frequencies of 433.72MHz and 434. 12MHz, respectively. In other words, the difference between the predetermined upper reception frequency of 434.12MHz and the predetermined upper frequency of the variable frequency output signal of 423.42MHz is 10.7MHz, and similarly in the case of the respective predetermined lower reception frequency and the predetermined lower frequency of the variable frequency output signal, and in turn the respective thirty-two intermediate frequency values of the reception frequency and the variable frequency output signal.

An intermediate filter means, namely, an intermediate filter 10 receives the output from the mixer 5 and filters out all signals other than those at an intermediate frequency of 10.7MHz, namely, the difference between the frequency of a valid received signal at one of the reception frequencies within the reception frequency range, and the corresponding frequency of the variable frequency output signal within the predetermined frequency range. An amplifying means provided by an amplifier 12 amplifies the intermediate frequency signal, which in turn is fed to a demodulating means, namely, a demodulator 14. The demodulator 14 demodulates the signal from the amplifier 12 and relays the data part of the received signal to an output circuit 15.

A control means in this embodiment of the invention provided by a microprocessor 16 reads the data signal relayed to the output circuit 15 on a line 17, for determining if the data signal is of valid format. If so, a gate means, namely, a gate circuit 18 operated under the control of the microprocessor 16 through a line 21 outputs the data signal on an output line 19 to the electronic control unit (not shown) where suitable analysing circuitry (also not shown) in the electronic control unit determines if the received signal is a unique signal unique to the electronic control unit. The microprocessor 16 under the control of suitable software reads the data signal from the output circuit 15 and monitors the time between data edges of the signal for determining if the data signal is of the valid format.

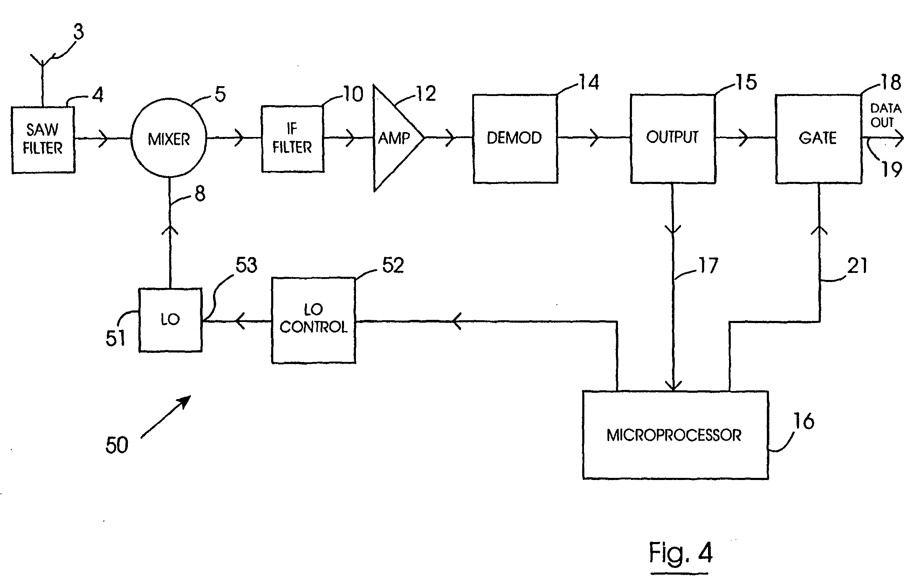

Referring now to Figs. 2 and 3 the variable frequency signal generating circuit 6 will now be described. The circuit 6 is operated under the control of the microprocessor 16 for generating and sweeping the variable frequency output signal through the frequency range of 400KHz from the predetermined lower frequency of 423.02MHz to the predetermined upper frequency of 423.42MHz in the form of a staircase signal in thirty-two incremental steps of 12.5 KHz each. Typical sweeps of the variable frequency output signal are illustrated in Fig. 3. In this embodiment of the invention each time the variable frequency output signal reaches the predetermined upper frequency of 423.42MHz the frequency of the variable frequency output signal is returned to the predetermined lower frequency of 423.02MHz. The frequency of the variable frequency output signal is maintained constant during each incremental step for a first predetermined time period sufficient to allow the microprocessor 16 determine if a signal has been received, and if so, if the received signal is of valid format. In this embodiment of the invention each incremental frequency step is maintained for a first predetermined time period of approximately one millisecond. On determining the existence of a received signal of valid format the microprocessor 16 operates the variable frequency signal generating circuit 6 to maintain the frequency of the variable frequency output signal constant at the frequency corresponding to that at which the received signal was received for a second predetermined time period sufficient to allow a series of received data signals to be outputted through the gate circuit 18 on the output line 19 to the electronic control unit (not shown). In this embodiment of the invention the second predetermined time period is 250 milliseconds. As can be seen from Fig. 3 during the time period A the variable frequency output signal was swept through two sweeps without a signal in valid format having been received. During the third sweep after a time period B a signal of valid format was received and the frequency of the variable frequency output signal is held constant for the second predetermined time period C to allow a series of the data signals to be received and outputted to the electronic control unit (not shown). At the end of the second predetermined time period C the variable frequency signal generating circuit 6 under the control of the microprocessor 16 again continues the frequency sweep by incrementing the variable frequency output signal by the next step of 12.5KHz.

Referring now in particular to Fig. 2, the variable frequency signal generating circuit 6 is in the form of a phase locked loop control circuit and comprises a constant frequency signal generating means, which in this embodiment of the invention is provided by a crystal frequency signal generator 20 for generating a constant frequency signal at 6.6086 MHz. A variable frequency signal generating means provided by a voltage controlled oscillator 23 generates the variable frequency output signal which is outputted from the circuit 6 on the line 8 to the mixer 5. The variable frequency output signal from the voltage controlled oscillator 23 is also fed to a frequency divider circuit 24 which divides the frequency from the voltage controlled oscillator 23 by a factor of 64 so that the frequency of the signal from the frequency divider circuit 24 is more appropriately matched to that of the constant frequency signal outputted by the signal generator 20.

A phase comparing means, namely, a phase comparator 25 compares the respective signals received from the signal generator 20 and the frequency divider circuit 24 and outputs a signal, which is indicative of, and in this case proportional to the phase difference of the respective signals from the signal generator 20 and the frequency divider circuit 24. The signal from the phase comparator 25 is fed through a feedback loop 27 to a control input port 28 of the voltage controlled oscillator 23: A low pass filter 29 in the feedback loop 27 filters out high frequencies from the signal from the phase comparator 25. The signal from the phase comparator 25 becomes a DC voltage signal when the phase lock loop has locked-up.

A signal varying means for varying the voltage of the signal applied to the control input port 28 of the voltage controlled oscillator 23 for in turn varying the frequency of the variable frequency output signal from the voltage controlled oscillator 23 comprises a voltage adding means, namely, a voltage adder 30. The voltage adder 30 adds a variable DC voltage signal under the control of the microprocessor 16 to the value of the DC voltage signal from the phase comparator 25 when the circuit is locked-up and the feedback loop 27 is open by a first isolating means, namely, a first analogue switch SW1, as will be described below. In this way the voltage value of the signal applied to the control input port 28 of the voltage controlled oscillator 23 is the sum of the voltage of the DC signal from the phase comparator 25 when the circuit locked-up and the variable DC voltage applied by the microprocessor 16.

The variable voltage signal is derived from the microprocessor 16 through a digital-to-analogue converter 32. The microprocessor 16 generates a five bit word which is fed to the digital-to-analogue converter 32 on a bus 33 for controlling the digital-to-analogue converter 32 for outputting the variable DC voltage signal as a stepped voltage in the form of a staircase in thirty-two incremental steps for sweeping the variable frequency output signal through the corresponding thirty-two incremental frequency steps. The microprocessor 16 controls the digital-to-analogue converter 32 for sequentially incrementing the voltage of the variable DC voltage signal through the thirty-two incremental steps from a lower voltage value to an upper voltage value, and on the voltage of the variable DC voltage signal reaching the upper voltage value, the voltage is returned to the lower voltage value for in turn generating the variable frequency output signal as illustrated in Fig. 3. A voltage divider circuit 35 attenuates the voltage signal from the digital-to-analogue converter 32 and applies the attenuated voltage signal to a pin 2 of the adder 30. The attenuated voltage signal is of such a value that when summed with the voltage signal from the phase comparator 25 on a pin 1 of the adder 30, and applied to the control input port 28 of the voltage controlled oscillator 23, the variable frequency output signal from the voltage controlled oscillator 23 is swept between the predetermined lower and upper frequencies.

The first switch SW1 which is located in the feedback loop 27 under the control of the microprocessor 16 isolates the control input port 28 of the voltage controlled oscillator 23 from the phase comparator 25 when the circuit is locked-up for facilitating the voltage on pin 1 of the adder 30 to be maintained substantially constant at the voltage of the signal outputted by the phase comparator 25 when the circuit has locked-up. A retaining means for retaining the voltage on the pin 1 of the adder 30 substantially constant while the first switch SW1 is open comprises a capacitive retaining circuit 36 which comprises a capacitor C1 which is connected to ground through a first impedance means provided by a high impedance means, namely, a resistor R1 for facilitating charging of the capacitor C1 during periods when the first switch SW1 is closed as the circuit is being brought to its locked-up state. A second isolating means, namely, a second analogue switch SW2 bridges the resistor R1 for connecting the capacitor C1 to ground for maintaining the voltage on the pin 1 of the adder 30 substantially constant at the locked-up voltage after the circuit has locked-up and the first switch SW1 has been opened. The first and second switches SW1 and SW2 are operated under the control of the microprocessor 16 through control lines 37 and 38, respectively, and when the first switch SW1 is opened on the circuit being locked-up the second switch SW2 is closed for maintaining the voltage on the input pin 1 of the adder 30 substantially constant. When the first switch SW1 is closed for allowing the circuit to lock-up, the second switch SW2 is open for facilitating charging of the capacitor C1 through the resistor R1.

A high impedance voltage follower 39 in the feedback loop 27 between the adder 30 and the capacitive retaining circuit 36 minimises leakage through the pin 1 of the adder 30.

Operation of the circuit 6 will now be described. Initially, with the first switch SW1 closed and the second switch SW2 open and the voltage outputted by the digital-to-analogue converter 32 at zero volts, the circuit 6 operates as a phase locked loop circuit with the signal from the phase comparator 25 being applied to the control input port 28 of the voltage controlled oscillator 23. After a short lock-up time the phase locked loop circuit becomes locked-up, in other words, locked in frequency and phase to a multiple of the frequency of the signal generator 20, depending on the frequency divider circuit 24. After the phase locked loop circuit has become locked and the capacitor C1 has fully charged, the microprocessor 16 through the control lines 37 and 38 simultaneously opens the first switch SW1 and closes the second switch SW2, and the capacitor C1 holds the voltage on the pin 1 of the adder 30 substantially constant at the value at which it was prior to opening of the first switch SW1. The microprocessor 16 sequentially increments the five bit word on the bus 33 at intervals corresponding to the first predetermined time period, and outputs the five bit word to the digital to analogue converter 32, which in turn, outputs the stepped DC voltage which is in turn attenuated and applied to the pin 2 of the voltage adder 30. The voltage adder 30 sums the stepped voltage to the voltage being maintained on the pin 1 of the adder 30 by the capacitor C1, and the summed voltage is applied to the control input port 28 of the voltage controlled oscillator 23. The staircase voltage on the control input port 28 causes the voltage controlled oscillator 23 to output the staircase variable frequency output signal of Fig. 3.

Due to the fact that some leakage occurs from the capacitor C1 while the first switch SW1 is open, periodically the microprocessor 16 simultaneously closes the first switch SW1 and opens the second switch SW2 for allowing the circuit 6 to again operate as a phase locked loop circuit for locking up of the circuit, and in turn charging the capacitor C1. After a short lock-up period and when the capacitor C1 has been charged, the microprocessor 16 simultaneously opens the first switch SW1 and closes the second switch SW2. Typically, the capacitor C1 will require charging between the respective staircase cycles of the variable frequency output signal, and the circuit is operated in its phase locked loop form when the voltage on pin 2 of the adder 30 from the digital to analogue converter 32 is zero volts.

In the event that the microprocessor 16 determines the presence of a received signal of valid format in the output circuit 15, the microprocessor 16 holds the voltage output of the digital to analogue converter 32 constant for the second predetermined time period corresponding to the period C in Fig. 3 so that the valid signal can be gated through the gate circuit 18 to the electronic control unit (not shown). After the received signal has been outputted to the electronic control unit (not shown) the microprocessor 16 again controls the digital to analogue converter 32 for incrementing the voltage to the pin 2 of the adder 30 to the next voltage value and so on to produce the staircase frequency output signal of Fig. 3.

Referring now to Fig. 4 there is illustrated a narrow band variable frequency radio receiver according to another embodiment of the invention indicated generally by the reference numeral 50. The radio receiver 50 is substantially similar to the radio receiver 1 and similar components are identified by the same reference numerals. The main difference between the receiver 50 and the receiver 1 is that the variable frequency output signal on the line 8 to the mixer 5 instead of being derived from the variable frequency signal generating circuit 6 of the receiver 1 is derived from a local oscillator 51 which in this embodiment of the invention is also provided by a voltage controlled oscillator under the control of a local oscillator controller 52, which in turn is operated under the control of the microprocessor 16. The oscillator controller 52 provides a swept stepped DC voltage to a control input port 53 of the local oscillator 51 which is similar to that which is applied to the control input port 28 of the voltage controlled oscillator 23 of the receiver 1. This, thus, controls the local oscillator 51 for outputting the variable frequency output signal in the form of a staircase identical to that illustrated in Fig. 3.

As well as the oscillator 52 being operated under the control of the microprocessor 16 for providing the stepped staircase DC voltage to the control input port 53 of the local oscillator 51, the oscillator controller 52 is also controlled by the microprocessor 16 for maintaining the voltage on the control input pin 53 of the local oscillator 52 for the second predetermined time period in the event of the microprocessor 2 determining the existence of a received signal of valid format so that a series of the received signals can be outputted through the gate circuit 18 to an electronic control unit of a motor vehicle as already described with reference to Figs. 1 to 3.

While in the embodiments of the invention described with reference to Figs. 1 to 4 the receivers have been described as comprising respective microprocessors, it is envisaged in certain cases that the receivers may form part of the electronic control unit of the motor vehicle, and in which case, the microprocessors of the receivers described with reference to Figs. 1 to 4 may be replaced with the microprocessors of electronic control units.

## Claims

1. A variable frequency receiver for receiving a remotely transmitted signal within a predetermined reception frequency range, **characterised in that** the receiver comprises a receiving means (3) for receiving the remotely transmitted signal, a variable frequency signal generating means (51) for outputting a variable frequency output signal, a mixing means (5) for mixing the received signal with the variable frequency output signal and for outputting the mixed signal at a frequency dependent on the frequency of the variable frequency output signal and the frequency of the received signal, a gate means (18) for outputting a signal derived from the mixed signal, and a control means (16) for reading the signal from the mixed signal and for determining if the received signal is a valid signal, the control means (16) controlling the gate means (18) for outputting the signal derived from the mixed signal in response to the received signal being a valid signal, the control means (16) controlling the variable frequency signal generating means (51) for holding the frequency of the variable frequency output signal constant until the signal derived from the mixed signal has been outputted through the gate means (18).

2. A receiver as claimed in Claim 1 **characterised in that** the control means (16) operates the variable frequency signal generating means (51) for selectively and sequentially varying the frequency of the variable frequency output signal for sweeping the variable frequency output signal through a predetermined frequency range between a predetermined lower frequency and a predetermined upper frequency.

3. A receiver as claimed in Claim 1 or 2 **characterised in that** the variable frequency signal generating means (23) is in the form of a phase locked loop circuit and comprises a variable frequency voltage controlled oscillator (23) having a control input port (28) for receiving a control signal for determining the output frequency of the variable frequency output signal of the voltage controlled oscillator (23), a constant frequency signal generating means (20) for generating a constant frequency signal, a phase comparing means (25) for comparing the variable frequency output signal with the constant frequency signal and for outputting a signal indicative of the phase shift between the two signals, a feedback loop (27) for feeding back the signal from the phase comparing means (25) to the control input port (28) of the voltage controlled oscillator (23) for completing the phase locked loop circuit, a first isolating means (SW1) in the feedback loop (27) for isolating the control input port (28) of the voltage controlled oscillator (23) from the phase comparing means (25) when the circuit has locked-up, a retaining means (36) for holding the signal from the phase comparing means (25) on the control input port (28) of the voltage controlled oscillator (23) after the first isolating means (SW1) has isolated the control input port (28) from the phase comparing means (25), a signal varying means (32) for selectively varying the signal on the control input port (28) of the voltage controlled oscillator (23) while the control input port (28) is isolated from the phase comparing means (25) for in turn selectively varying the frequency of the variable frequency output signal, and the first isolating means (SW1) being controlled by the control means (16) for isolating the control input port (28) from the phase comparing means (25) and for operating the signal varying means (32) for selectively varying the signal on the control input port (28) when the control input port (28) is isolated from the phase comparing means (25).

4. A receiver as claimed in Claim 3 **characterised in that** the control means (16) controls the signal varying means (32) for selectively and sequentially incrementing or decrementing the value of the signal on the control input port (28) over a predetermined range of signal values between a predetermined lower signal value and a predetermined upper signal value for sweeping the frequency of the variable frequency output signal through the predetermined frequency range.

5. A receiver as claimed in Claim 4 **characterised in that** the control means (16) controls the signal varying means (32) for holding the signal value on the control input port (28) of the voltage controlled oscillator (23) constant at each signal value within the predetermined range of signal values for a first predetermined time period.

6. A receiver as claimed in Claim 5 **characterised in that** the control means (16) controls the signal varying means (32) for holding the value of the signal on the control input port (28) of the voltage controlled oscillator (23) constant at selected signal values within the predetermined range of signal values for a second predetermined time period, the second predetermined time period being greater than the first predetermined time period.

7. A receiver as claimed in Claim 6 **characterised in that** the control means (16) is responsive to the presence of a valid received signal for controlling the signal varying means (32) for holding the signal value on the control input port (28) of the voltage controlled oscillator (23) constant for in turn holding the frequency of the variable frequency output signal constant for the second predetermined time period for facilitating reception of the received signal.

8. A receiver as claimed in Claim 6 or 7 **characterised in that** the second predetermined time period is of sufficient duration for facilitating reception of at least one valid received signal.

9. A receiver as claimed in any of Claims 4 to 8 **characterised in that** the control means (16) controls the signal varying means (32) for selectively and sequentially incrementing the signal on the control input port (28) of the voltage controlled oscillator (23) through a plurality of incremental signal value steps from the lower predetermined signal value to the upper predetermined signal value for sweeping the variable frequency output signal through the predetermined frequency range.

10. A receiver as claimed in any of Claims 3 to 9 **characterised in that** the signal outputted from the phase comparing means (25) is a DC voltage signal when the phase lock loop has locked-up.

11. A receiver as claimed in Claim 10 **characterised in that** the signal varying means (32) comprises a means for selectively and sequentially generating a variable DC voltage, and an adding means (30) for adding the variable DC voltage to the voltage signal from the phase comparing means (25) held on the control input port (28) of the voltage controlled oscillator (23).

12. A receiver as claimed in Claim 11 **characterised in that** the signal varying means (32) comprises a digital to analogue converter (32) operating under the control of the control means (16) for outputting the variable DC voltage to the control input port (28) of the voltage controlled oscillator (23).

13. A receiver as claimed in any of Claims 3 to 12 **characterised in that** the retaining means (36) is provided by a capacitive retaining circuit (36) connected to the feedback loop (27) between the first isolating means (SW1) and the signal varying means (32).

14. A receiver as claimed in Claim 13 **characterised in that** the capacitive retaining circuit (36) comprises a capacitor (C1 ) connected between the feedback loop (27) and ground, and a first impedance means (R1) is provided in the capacitive retaining circuit (36) for smoothing charging of the capacitor (C1) during periods when the control input port (28) of the voltage controlled oscillator (23) is communicating with the phase comparing means (25).

15. A receiver a claimed in Claim 14 **characterised in that** a second isolating means (SW2) operable under the control of the control means (16) is provided in the capacitive circuit (36) for switching out the first impedance means (R1) when the control input port (28) of the voltage controlled oscillator (23) is isolated from the phase comparing means (25).

16. A receiver as claimed in any of Claims 3 to 15 **characterised in that** the control means (16) operates the first isolating means (SW1) periodically for closing the feedback loop (27) for communicating the control input port (28) of the voltage controlled oscillator (23) with the phase comparing means (25) for permitting periodic lock-up of the phase locked loop circuit for avoiding deterioration of the signal on the control input port (28).

17. A remote keyless entry system for a motor vehicle comprising the variable frequency receiver as claimed in any preceding claim.

## Patentansprüche

1. Empfänger für durchstimmbare Frequenzen zum Empfang eines fernübertragenen Signals innerhalb eines festgelegten Empfangsfrequenzbereichs, **dadurch gekennzeichnet, dass** der Empfänger eine Empfangseinrichtung (3) zum Empfang des fernübertragenen Signals, eine Signalerzeugungseinrichtung (51) für durchstimmbare Frequenzen zum Ausgeben eines durchstimmbaren Frequenzausgangssignals, eine Mischeinrichtung (5) zum Mischen des empfangenen Signals mit dem durchstimmbaren Frequenzausgangssignal und zum Ausgeben des gemischten Signals auf einer Frequenz, die von der Frequenz des durchstimmbaren Frequenzausgangssignals und der Frequenz des empfangenen Signals abhängt, eine Toreinrichtung (18) zum Ausgeben eines Signals, das aus dem gemischten Signal abgeleitet wurde, und eine Steuereinrichtung (16) zum Einlesen des Signals aus dem gemischten Signal und zum Bestimmen, ob das empfangene Signal ein gültiges Signal ist, aufweist, wobei die Steuereinrichtung (16) die Toreinrichtung (18) zum Ausgeben des Signals steuert, das von dem gemischten Signal als Antwort auf das empfangene Signal, das ein gültiges Signal ist, abgeleitet wurde, wobei die Steuereinrichtung (16) die Signalerzeugungseinrichtung (51) für durchstimmbare Frequenzen steuert, um die Frequenz des durchstimmbaren Frequenzausgangssignals konstant zu halten, bis das von dem gemischten Signal abgeleitete Signal durch die Toreinrichtung (18) ausgegeben wurde.

2. Empfänger wie in Anspruch 1 beansprucht, **dadurch gekennzeichnet, dass** die Steuereinrichtung (16) die Signalerzeugungseinrichtung (51) für durchstimmbare Frequenzen betreibt, um die Frequenz des durchstimmbaren Frequenzausgangssignals selektiv und sequentiell zu variieren, so dass das durchstimmbare Frequenzausgangssignal einen festgelegten Frequenzbereich zwischen einer festgelegten unteren Frequenz und einer festgelegten oberen Frequenz durchläuft

3. Empfänger wie in Anspruch 1 oder 2 beansprucht, **dadurch gekennzeichnet, dass** die Signalerzeugungseinrichtung (23) für durchstimmbare Frequenzen als PLL-Kreis ausgebildet ist und einen durchstimmbaren spannungsgesteuerten Frequenzoszillator (23) mit einem Steuereingangsanschluss (28) zum Empfangen eines Steuersignals zum Bestimmen der Ausgangsfrequenz des durchstimmbaren Frequenzausgangssignals des spannungsgesteuerten Oszillators (23), eine Konstantfrequenzsignalerzeugungseinrichtung (20) zum Erzeugen eines konstanten Frequenzsignals, eine Phasenvergleichseinrichtung (25) zum Vergleichen des variablen Frequenzausgangssignal mit dem konstanten Frequenzsignal und zum Ausgeben eines Signals, das die Phasenverschiebung zwischen den beiden Signalen anzeigt, eine Rückkopplungsschleife (27) zum Rückkoppeln des Signals der Phasenvergleichseinrichtung (25) an den Steuereingangsanschluss (28) des spannungsgesteuerten Oszillators (23) zum Vervollständigen des PLL-Kreises, eine ersten Isolationseinrichtung (SW1) in der Rückkopplungsschleife (27) zum Isolieren des Steuereingangsanschlusses (28) des spannungsgesteuerten Oszillators (23) gegen die Phasenvergleichseinrichtung (25), wenn der Schaltkreis gesperrt ist, eine Rückhalteeinrichtung (36) zum Halten des Signals der Phasenvergleichseinrichtung (25) auf dem Steuereingangsanschluss (28) des spannungsgesteuerten Oszillators. (23), nachdem die erste Isolationseinrichtung (SW1) den Steuereingangsanschluss (28) gegen die Phasenvergleichseinrichtung (25) isoliert hat, eine Signalvariierungseinrichtung (32) zum selektiven Variieren des Signals an dem Steuereingangsanschluss (28) des spannungsgesteuerten Oszillators (23), während der Steuereingangsanschluss (28) gegen die Phasenvergleichseinrichtung (25) isoliert ist, um im Gegenzug die Frequenz des durchstimmbaren Frequenzausgangssignals selektiv zu variieren, aufweist und wobei die erste Isolationseinrichtung (SW1) durch die Steuereinrichtung (16) zum Isolieren des Steuereingangsanschlusses (28) gegen die Phasenvergleichseinrichtung (25) gesteuert wird und zum Betreiben der Signalvariierungseinrichtung (32) zum selektiven Variieren des Signals auf dem Steuereingangsanschluss (28), wenn der Steuereingangsanschluss (28) gegen die Phasenvergleichseinrichtung (25) isoliert ist.

4. Empfänger wie in Anspruch 3 beansprucht, **dadurch gekennzeichnet, dass** die Steuereinrichtung (16) die Signalvariierungseinrichtung (32) steuert, um selektiv und sequentiell den Wert des Signals an dem Steuereingangsanschluss (28) über einen festgelegten Bereich von Signalwerten zwischen einem festgelegten unteren Signalwert und einen festgelegten oberen Signalwert zu erhöhen und zu verringern, so dass die Frequenz des durchstimmbaren Frequenzausgangssignals einen festgelegten Frequenzbereich durchläuft.

5. Empfänger wie in Anspruch 4 beansprucht, **dadurch gekennzeichnet, dass** die Steuereinrichtung (16) die Signalvariierungseinrichtung (32) steuert, um den Signalwert an dem Steuereingangsanschluss (28) des spannungsgesteuerten Oszillators (23) bei jedem Signalwert innerhalb des festgelegten Bereichs von Signalwerten während einer ersten festgelegten Zeitspanne konstant zu halten.

6. Empfänger wie in Anspruch 5 beansprucht, **dadurch gekennzeichnet, dass** die Steuereinrichtung (16) die Signalvariierungseinrichtung (32) steuert, um den Signalwert an dem Steuereingangsanschluss (28) des spannungsgesteuerten Oszillators (23) bei ausgewählten Signalwerten innerhalb des festgelegten Bereichs von Signalwerten während einer zweiten festgelegten Zeitspanne konstant zu halten, wobei die zweite festgelegte Zeitspanne länger als die erste festgelegte Zeitspanne ist.

7. Empfänger wie in Anspruch 6 beansprucht, **dadurch gekennzeichnet, dass** die Steuereinrichtung (16) auf die Präsenz eines gültigen empfangenen Signals zum Steuern der Signalvariierungseinrichtung (32) anspricht, um den Signalwert an dem Steuereingangsanschluss (28) des spannungsgesteuerten Oszillators (23) konstant zu halten, wobei im Gegenzug die Frequenz des durchstimmbaren Frequenzausgangssignals für die zweite festgelegte Zeitspanne konstant gehalten wird, um den Empfang des empfangenen Signals zu ermöglichen.

8. Empfänger wie in Anspruch 6 oder 7 beansprucht, **dadurch gekennzeichnet, dass** die zweite Zeitspanne von ausreichender Dauer ist, um den Empfang von zumindest einem gültigen empfangenen Signal zu ermöglichen.

9. Empfänger wie in einem der Ansprüche 4 bis 8 beansprucht, **dadurch gekennzeichnet, dass** die Steuereinrichtung (16) die Signalvariierungseinrichtung (32) zum selektiven und sequentiellen Erhöhen des Signalwerts an dem Steuereingangsanschluss (28) über eine Mehrzahl von den Signalwert erhöhenden Schritten von dem unteren festgelegten Signalwert zu dem oberen festgelegten Signalwert steuert, so dass die Frequenz des durchstimmbaren Frequenzausgangssignals in einem festgelegten Frequenzbereich durchläuft.

10. Empfänger wie in einem der Ansprüche 3 bis 9 beansprucht, **dadurch gekennzeichnet, dass** das von der Phasenvergleichseinrichtung (25) ausgegebene Signal ein Gleichspannungssignal ist, wenn der PLL-Kreis gesperrt ist.

11. Empfänger wie in Anspruch 10 beansprucht, **dadurch gekennzeichnet, dass** die Signalvariierungseinrichtung (32) eine Einrichtung zum selektiven und sequentiellen Erzeugen einer variablen Gleichspannung und eine Additionseinrichtung (30) zum Addieren der variablen Gleichspannung zu dem Spannungssignal der Phasenvergleichseinrichtung (25) aufweist, das an dem Steuereingangsanschluss (28) des spannungsgesteuerten Oszillators (23) anliegt.

12. Empfänger wie in Anspruch 11 beansprucht, **dadurch gekennzeichnet, dass** die Signalvariierungseinrichtung (32) einen Digital-Analog-Umsetzer (32) enthält, der unter der Steuerung der Steuereinrichtung (16) betrieben wird, um die variable Gleichspannung an den Steuereingangsanschluss (28) des spannungsgesteuerten Oszillators (23) auszugeben.

13. Empfänger wie in einem der Ansprüche 3 bis 12 beansprucht, **dadurch gekennzeichnet, dass** die Rückhalteeinrichtung (36) durch einen kapazitiven Rückhaltekreis (36) ausgebildet ist, der mit der Rückkopplungsschleife (27) zwischen der ersten Isolationseinrichtung (SW1) und der Signalvariierungseinrichtung (32) verbunden ist.

14. Empfänger wie in Anspruch 13 beansprucht, **dadurch gekennzeichnet, dass** der kapazitive Rückhaltekreis (36) einen Kondensator (C1) aufweist, der zwischen der Rückkopplungsschleife (27) und Masse angeordnet ist, und dass eine erste Impedanzeinrichtung (R1) in dem kapazitiven Rückhaltekreis (36) vorgesehen ist, um das Laden des Kondensators (C1) während Zeiträumen zu glätten, in der der Steuereingangsanschluss (28) des spannungsgesteuerten Oszillators (23) mit der Phasenvergleichseinrichtung (25) kommuniziert.

15. Empfänger wie in Anspruch 14 beansprucht, **dadurch gekennzeichnet, dass** eine zweite Isolationseinrichtung (SW2), die unter der Steuerung der Steuereinrichtung (16) betrieben wird, in dem kapazitiven Kreis (36) zum Ausschalten der ersten Impedanzeinrichtung (R1) vorgesehen ist, wenn der Steuereingangsanschluss (28) des spannungsgesteuerten Oszillators (23) gegen die Phasenvergleichseinrichtung (25) isoliert ist.

16. Empfänger wie in einem der Ansprüche 3 bis 15 beansprucht, **dadurch gekennzeichnet, dass** die Steuereinrichtung (16) die erste Isolationseinrichtung (SW1) periodisch betreibt, um die Rückkopplungsschleife (27) für ein Kommunizieren des Steuereingangsanschlusses (28) des spannungsgesteuerten Oszillators (23) mit der Phasenvergleichseinrichtung (25) zu schließen, um ein periodisches Sperren des PLL-Kreises zum Vermeiden von Signalverschlechterung an dem Steuereingangsanschluss (28) zu erlauben .

17. System zum entfernten, schlüssellosen Öffnen eines Kraftfahrzeugs, umfassend den Empfänger für durchstimmbare Frequenzen wie in einem der vorangegangenen Ansprüche beansprucht.

## Revendications

1. Récepteur à fréquence variable pour recevoir un signal transmis à distance à l'intérieur d'une gamme de fréquences de réception prédéterminée, **caractérisé en ce que** le récepteur comprend un moyen de réception (3) pour recevoir le signal transmis à distance, un moyen de génération de signaux à fréquence variable (51) pour sortir un signal de sortie à fréquence variable, un moyen de mélange (5) pour mélanger le signal reçu avec le signal de sortie à fréquence variable et pour sortir le signal mélangé à une fréquence dépendante de la fréquence du signal de sortie à fréquence variable et de la fréquence du signal reçu, un moyen formant porte (18) pour sortir un signal dérivé du signal mélangé, et un moyen de commande (16) pour lire le signal à partir du signal mélangé et pour déterminer si le signal reçu est un signal valide, le moyen de commande (16) commandant le moyen formant porte (18) pour sortir le signal dérivé du signal mélangé en réponse au signal reçu qui est un signal valide, le moyen de commande (16) commandant le moyen de génération de signaux à fréquence variable (51) pour maintenir la fréquence du signal de sortie à fréquence variable constante jusqu'à ce que le signal dérivé du signal mélangé ait été sorti par le moyen formant porte (18).

2. Récepteur selon la revendication 1, **caractérisé en ce que** le moyen de commande (16) actionne le moyen de génération de signaux à fréquence variable (51) pour faire varier sélectivement et séquentiellement la fréquence du signal de sortie à fréquence variable pour balayer le signal de sortie à fréquence variable à travers une gamme de fréquences prédéterminée entre une fréquence inférieure prédéterminée et une fréquence supérieure prédéterminée.

3. Récepteur selon la revendication 1 ou 2, **caractérisé en ce que** le moyen de génération de signaux à fréquence variable (23) est sous la forme d'un circuit à boucle à verrouillage de phase et comprend un oscillateur commandé en tension à fréquence variable (23) ayant un port d'entrée de commande (28) pour recevoir un signal de commande pour déterminer la fréquence de sortie du signal de sortie à fréquence variable de l'oscillateur commandé en tension (23), un moyen de génération de signaux à fréquence constante (20) pour générer un signal à fréquence constante, un moyen de comparaison de phase (25) pour comparer le signal de sortie à fréquence variable avec le signal à fréquence constante et pour sortir un signal indicatif du déplacement de phase entre les deux signaux, une boucle de rétroaction (27) pour réinjecter le signal du moyen de comparaison de phase (25) au port d'entrée de commande (28) de l'oscillateur commandé en tension (23) pour fermer le circuit à boucle à verrouillage de phase, un premier moyen d'isolation (SW1) dans la boucle de rétroaction (27) pour isoler le port d'entrée de commande (28) de l'oscillateur commandé en tension (23) du moyen de comparaison de phase (25) lorsque le circuit est verrouillé, un moyen de retenue (36) pour maintenir le signal du moyen de comparaison de phase (25) sur le port d'entrée de commande (28) de l'oscillateur commandé en tension (23) après que le premier moyen d'isolation (SW1) a isolé le port d'entrée de commande (28) du moyen de comparaison de phase (25), un moyen de variation de signal (32) pour faire varier sélectivement le signal sur le port d'entrée de commande (28) de l'oscillateur commandé en tension (23) tandis que le port d'entrée de commande (28) est isolé du moyen de comparaison de phase (25) pour à son tour faire varier sélectivement la fréquence du signal de sortie à fréquence variable, et le premier moyen d'isolation (SW1) étant commandé par le moyen de commande (16) pour isoler le port d'entrée de commande (28) du moyen de comparaison de phase (25) et pour actionner le moyen de variation de signal (32) pour faire varier sélectivement le signal sur le port d'entrée de commande (28) lorsque le port d'entrée de commande (28) est isolé du moyen de comparaison de phase (25).

4. Récepteur selon la revendication 3, **caractérisé en ce que** le moyen de commande (16) commande le moyen de variation de signal (32) pour incrémenter ou décrémenter sélectivement et séquentiellement la valeur du signal sur le port d'entrée de commande (28) sur une gamme prédéterminée de valeurs de signal entre une valeur de signal inférieure prédéterminée et une valeur de signal supérieure prédéterminée pour balayer la fréquence du signal de sortie à fréquence variable à travers la gamme de fréquences prédéterminée.

5. Récepteur selon la revendication 4, **caractérisé en ce que** le moyen de commande (16) commande le moyen de variation de signal (32) pour maintenir la valeur de signal sur le port d'entrée de commande (28) de l'oscillateur commandé en tension (23) constante à chaque valeur de signal à l'intérieur de la gamme prédéterminée de valeurs de signal pendant une première période de temps prédéterminée.

6. Récepteur selon la revendication 5, **caractérisé en ce que** le moyen de commande (16) commande le moyen de variation de signal (32) pour maintenir la valeur du signal sur le port d'entrée de commande (28) de l'oscillateur commandé en tension (23) constante à des valeurs de signal sélectionnées à l'intérieur de la gamme prédéterminée de valeurs de signal pendant une seconde période de temps prédéterminée, la seconde période de temps prédéterminée étant plus grande que la première période de temps prédéterminée.

7. Récepteur selon la revendication 6, **caractérisé en ce que** le moyen de commande (16) est sensible à la présence d'un signal reçu valide pour commander le moyen de variation de signal (32) pour maintenir la valeur de signal sur le port d'entrée de commande (28) de l'oscillateur commandé en tension (23) constante pour à son tour maintenir la fréquence du signal de sortie à fréquence variable constante pendant la seconde période de temps prédéterminée pour faciliter la réception du signal reçu.

8. Récepteur selon la revendication 6 ou 7,
**caractérisé en ce que** la seconde période de temps prédéterminée est d'une durée suffisante pour faciliter la réception d'au moins un signal reçu valide.

9. Récepteur selon l'une quelconque des revendications 4 à 8, **caractérisé en ce que** le moyen de commande (16) commande le moyen de variation de signal (32) pour incrémenter sélectivement et séquentiellement le signal sur le port d'entrée de commande (28) de l'oscillateur commandé en tension (23) à travers une pluralité de pas de valeur de signal incrémentaux de la valeur de signal prédéterminée inférieure à la valeur de signal prédéterminée supérieure pour balayer le signal de sortie à fréquence variable à travers la gamme de fréquences prédéterminée.

10. Récepteur selon l'une quelconque des revendications 3 à 9, **caractérisé en ce que** le signal sorti du moyen de comparaison de phase (25) est un signal de tension CC lorsque la bouche à verrouillage de phase est verrouillée.

11. Récepteur selon la revendication 10, **caractérisé en ce que** le moyen de variation de signal (32) comprend un moyen pour générer sélectivement et séquentiellement une tension CC variable, et un moyen d'addition (30) pour ajouter la tension CC variable à la tension du signal du moyen de comparaison de phase (25) maintenu sur le port d'entrée de commande (28) de l'oscillateur commandé en tension (23).

12. Récepteur selon la revendication 11, **caractérisé en ce que** le moyen de variation de signal (32) comprend un convertisseur numérique-analogique (32) fonctionnant sous le contrôle du moyen de commande (16) pour sortir la tension CC variable sur le port d'entrée de commande (28) de l'oscillateur commandé en tension (23).

13. Récepteur selon l'une quelconque des revendications 3 à 12, **caractérisé en ce que** le moyen de retenue (36) est fourni par un circuit de retenue capacitif (36) relié à la boucle de rétroaction (27) entre le premier moyen d'isolation (SW1) et le moyen de variation de signal (32).

14. Récepteur selon la revendication 13, **caractérisé en ce que** le circuit de retenue capacitif (36) comprend un condensateur (C1) relié entre la boucle de rétroaction (27) et la terre, et un premier moyen d'impédance (R1) est pourvu dans le circuit de retenue capacitif (36) pour lisser la charge du condensateur (C1) durant les périodes où le port d'entrée de commande (28) de l'oscillateur commandé en tension (23) communique avec le moyen de comparaison de phase (25).

15. Récepteur selon la revendication 14, **caractérisé en ce qu'**un second moyen d'isolation (SW2) actionnable sous le contrôle du moyen de commande (16) est pourvu dans le circuit capacitif (36) pour arrêter le premier moyen d'impédance (R1) lorsque le port d'entrée de commande (28) de l'oscillateur commandé en tension (23) est isolé du moyen de comparaison de phase (25).

16. Récepteur selon l'une quelconque des revendications 3 à 15, **caractérisé en ce que** le moyen de commande (16) actionne le premier moyen d'isolation (SW1) périodiquement pour fermer la boucle de rétroaction (27) pour faire communiquer le port d'entrée de commande (28) de l'oscillateur commandé en tension (23) avec le moyen de comparaison de phase (25) pour permettre le verrouillage périodique du circuit à boucle à verrouillage de phase pour éviter la détérioration du signal sur le port d'entrée de commande (28).

17. Système d'entrée sans clé à distance pour un véhicule à moteur comprenant le récepteur à fréquence. variable selon l'une quelconque des revendications précédentes.
